# EUROPEAN PATENT APPLICATION

(11) **EP 4 715 604 A1**
(43) Date of publication of application: **25.03.2026**
(21) Application number: 24824923.7
(22) Date of filing: 01.03.2024
(51) Int. Cl.: G06F 12/02, G06F 12/1009, G06F 12/1027

(54) **MEMORY PAGE PROCESSING METHOD, DEVICE AND APPARATUS, AND STORAGE MEDIUM**

(30) Priority: 20.06.2023 CN 202310740304; 25.08.2023 CN 202311086477
(71) Applicant: Huawei Technologies Co., Ltd., Shenzhen, Guangdong 518129 (CN)
(72) Inventor: LI, Zheng, Shenzhen, Guangdong 518129 (CN); JIANG, Shunning, Shenzhen, Guangdong 518129 (CN); PENG, Jie, Shenzhen, Guangdong 518129 (CN)
(74) Representative: Maiwald GmbH
(86) International application number: PCT/CN2024/079614
(87) International publication number: WO 2024/260020

(57) **Abstract**

This application discloses a memory page processing method and device, an apparatus, and a storage medium, and pertains to the field of communication technologies. According to the method, after a memory page is allocated to a virtual address that causes a page fault, the allocated memory page is pre-padded with first data, and then the memory page padded with the first data is accessed. Subsequently, if data in the memory page is migrated to a cache, the first data padded in the memory page is also migrated to the cache. If the data in the memory page is evicted from the cache to a memory, the evicted cache data may also include the first data. Because the first data is data in a data sequence corresponding to a cache compression mode, when the cache data including the first data is evicted back to the memory, a probability that the cache data matches the cache compression mode can be increased. In this way, a compression ratio of the cache data can be increased.

## Description

This application claims priority to Chinese Patent Application No. 202310740304.0, filed on June 20, 2023 and entitled "MEMORY SETTING METHOD", which is incorporated herein by reference in its entirety.

This application claims priority to Chinese Patent Application No. 202311086477.1, filed on August 25, 2023 and entitled "MEMORY PAGE PROCESSING METHOD AND DEVICE, APPARATUS, AND STORAGE MEDIUM", which is incorporated herein by reference in its entirety.

### TECHNICAL FIELD

This application relates to the field of communication technologies, and in particular, to a memory page processing method and device, an apparatus, and a storage medium.

### BACKGROUND

To alleviate a performance bottleneck caused by a memory wall, in a related technology, an attempt is made to bridge a performance gap between a central processing unit (central processing unit, CPU) and a memory through optimization at a microarchitecture level. For example, in a design of a chip microarchitecture, an attempt is made to reduce an amount of data in off-chip communication by using a cache compression technology, for example, frequent pattern compression (frequent pattern compression, FPC). Specifically, when data in a cache of the CPU is evicted from a cache line (cache line) to the memory, a memory management unit (memory management unit, MMU) compresses the data in the cache line based on a cache compression mode that matches the data in the cache line, to obtain compressed data. The compressed data is stored in the memory, to evict the data in the cache line to the memory.

However, in addition to data written by an application program, the cache line may further include some random values. As a result, the data in the cache line cannot well match a data compression mode. Data that does not match a data compression mode cannot be stored in the memory in a compressed manner when being evicted from the cache line, reducing a compression ratio of cache data when data is evicted from the cache to the memory.

### SUMMARY

Embodiments of this application provide a memory page processing method and device, an apparatus, and a storage medium, to increase a compression ratio of cache data. The technical solutions are as follows:

According to a first aspect, a memory page processing method is provided. The method includes the following steps: when a virtual address (referred to as a first virtual address) accessed by an application program causes a page fault, allocating a memory page (referred to as a first memory page) to the first virtual address; padding the first memory page with data (referred to as first data) in a data sequence corresponding to a cache compression mode, where the cache compression mode is a data compression mode used when data written by the application program in a cache is migrated to the memory page; and then accessing the padded first memory page based on the first virtual address.

According to the method, after the memory page is allocated to the virtual address that causes the page fault, the allocated memory page is pre-padded with the first data, and then the memory page padded with the first data is accessed. Subsequently, if data in the memory page is migrated to the cache, the first data padded in the memory page is also migrated to the cache. If the data in the memory page is evicted from the cache to a memory, the evicted cache data may also include the first data. Because the first data is the data in the data sequence corresponding to the cache compression mode, when the cache data including the first data is evicted back to the memory, a probability that the cache data matches the cache compression mode can be increased. In this way, a compression ratio of the cache data can be increased.

In a possible implementation, a process of padding the first memory page with the first data may be: padding the first memory page with the first data when the application program enables a memory pre-padding function, where the memory pre-padding function indicates to pad an empty memory page with the first data before the application program accesses the empty memory page.

Based on the foregoing possible implementation, a memory page allocated to the application program is pre-padded with the first data only when the application program enables the memory pre-padding function, and there is no need to pre-pad, with the first data, a memory page allocated to each running application program, to reduce a workload of padding the first data.

In a possible implementation, before the padding the first memory page with the first data when the application program enables the memory pre-padding function, the method further includes the following step: periodically enabling the memory pre-padding function for the application program based on a running status of the application program.

In a possible implementation, before the padding the first memory page with the first data when the application program enables the memory pre-padding function, the method further includes the following step: when a type of the application program is a target type, enabling the memory pre-padding function for the application program, where the cache compression mode is applicable to the application program of the target type.

Based on the foregoing possible implementation, the memory pre-padding function is enabled for the application program only when the cache compression mode is applicable to the application program, so that in a process of running the application program, the memory page of the application program is pre-padded with the first data, to improve compression efficiency when the data of the application program is migrated from the cache to the memory, and further avoid padding, with the first data, a memory page of an application program to which the cache compression mode is not applicable, to reduce a workload of padding the first data.

In a possible implementation, the accessing the padded first memory page based on the first virtual address includes the following steps: first receiving a first write request of the application program, where the first write request indicates to write second data to the first virtual address; and then updating the first data at a location corresponding to the first virtual address in the first memory page to the second data.

Based on the foregoing possible implementation, the first data is data padded before the application program writes data to the memory page. When subsequently writing data to the memory page, the application program only needs to update the first data to the to-be-written data. Therefore, a cache compression ratio is increased by pre-padding the first data without affecting normal data writing of the application program.

In a possible implementation, a plurality of second memory pages are all used to store task data of a same computing task of the application program, the plurality of second memory pages are all padded with the first data, and the method further includes the following steps: receiving a second write request of the application program, where the second write request indicates to write the task data to a second virtual address; and updating the first data at a location corresponding to the second virtual address in the plurality of second memory pages to the task data.

Based on the foregoing possible implementation, the plurality of memory pages corresponding to the same computing task are all padded with the first data. When the task data is written to any memory page, the first data in the memory page may be updated to the task data. Even if no task data is written to any one of the plurality of memory pages, a random value is not written to the memory page because of existence of the first data. Therefore, a case in which the random value affects compression of the cache data in the memory page can be avoided, so that a cache compression ratio can be increased.

In a possible implementation, the first data is each piece of data in the data sequence; the first data is S pieces of data that appear most frequently in the data sequence, where S is greater than 0; or the first data is R consecutive pieces of data in the data sequence, where R is greater than 0.

Based on the foregoing possible implementation, the first memory page is padded with the first data in the data sequence. If the data in the first memory page is subsequently migrated to the cache, and then the cache data in the first memory page is migrated from the cache, some first data in the cache data may still be retained in the cache, so that the cache data matches a data compression mode more easily, to further increase a compression ratio of the cache data.

In a possible implementation, the first data is S pieces of data that appear most frequently in a plurality of data sequences, where the plurality of data sequences correspond to different cache compression modes, and S is greater than 0; or the first data is data shared by the plurality of data sequences.

Based on the foregoing possible implementation, the first memory page is padded with the first data in the plurality of data sequences. If the data in the first memory page is subsequently migrated to the cache, and then the cache data in the first memory page is migrated from the cache, some first data in the cache data may still be retained in the cache, so that the cache data matches a plurality of data compression modes more easily. A probability that the cache data matches the data compression mode is increased, to further increase a compression ratio of the cache data.

According to a second aspect, a memory page processing method is provided. The method includes the following steps: after an allocation notification message is obtained, padding a first memory page with first data, where the allocation notification message is used to notify that the first memory page has been allocated to a first virtual address for a page fault caused by access of an application program to the first virtual address, the first data is data in a data sequence corresponding to a cache compression mode, and the cache compression mode is a data compression mode used when data written by the application program in a cache is migrated to the memory page.

In a possible implementation, the padding the first memory page with the first data includes the following step: padding the first memory page with the first data when the application program enables a memory pre-padding function, where the memory pre-padding function indicates to pad an empty memory page with the first data before the application program accesses the empty memory page.

In a possible implementation, before the padding the first memory page with the first data when the application program enables the memory pre-padding function, the method further includes the following step: periodically enabling the memory pre-padding function for the application program based on a running status of the application program.

In a possible implementation, before the padding the first memory page with the first data when the application program enables the memory pre-padding function, the method further includes the following step: when a type of the application program is a target type, enabling the memory pre-padding function for the application program, where the cache compression mode is applicable to the application program of the target type.

In a possible implementation, the first data is each piece of data in the data sequence; the first data is S pieces of data that appear most frequently in the data sequence, where S is greater than 0; or the first data is R consecutive pieces of data in the data sequence, where R is greater than 0.

In a possible implementation, the first data is S pieces of data that appear most frequently in a plurality of data sequences, where the plurality of data sequences correspond to different cache compression modes, and S is greater than 0; or the first data is data shared by the plurality of data sequences.

According to a third aspect, a memory page processing device is provided. The memory page processing device includes a functional module configured to perform the memory page processing method provided in any one of the first aspect or the optional manners of the first aspect.

According to a fourth aspect, a memory padding apparatus is provided. The memory padding apparatus includes a functional module configured to perform the memory page processing method provided in any one of the second aspect or the optional manners of the second aspect.

According to a fifth aspect, an electronic device is provided. The electronic device includes a processor, and the processor is configured to execute program code, to enable the electronic device to perform an operation performed to implement the memory page processing method provided in any one of the first aspect or the optional manners of the first aspect.

According to a sixth aspect, a memory padding apparatus is provided. The memory padding apparatus includes a processor, and the processor is configured to execute program code, to enable the memory padding apparatus to perform an operation performed to implement the memory page processing method provided in any one of the second aspect or the optional manners of the second aspect.

According to a seventh aspect, a computer-readable storage medium is provided. The storage medium stores at least one piece of program code, and the program code is read by a processor, to enable an electronic device to perform an operation performed by the memory page processing method provided in any one of the first aspect or the optional manners of the first aspect.

According to an eighth aspect, a computer-readable storage medium is provided. The storage medium stores at least one piece of program code, and the program code is read by a processor, to enable a memory padding apparatus to perform an operation performed by the memory page processing method provided in any one of the second aspect or the optional manners of the second aspect.

According to a ninth aspect, a computer program product or a computer program is provided. The computer program product or the computer program includes program code. The program code is stored in a computer-readable storage medium. A processor of an electronic device reads the program code from the computer-readable storage medium, and the processor executes the program code, to enable the electronic device to perform the method provided in the first aspect or the optional implementations of the first aspect.

According to a tenth aspect, a computer program product or a computer program is provided. The computer program product or the computer program includes program code. The program code is stored in a computer-readable storage medium. A processor of a memory padding apparatus reads the program code from the computer-readable storage medium, and the processor executes the program code, to enable the memory padding apparatus to perform the method provided in the second aspect or the optional implementations of the second aspect.

In this application, based on the implementations provided in the foregoing aspects, the implementations may be further combined to provide more implementations.

### BRIEF DESCRIPTION OF DRAWINGS

FIG. 1 is a diagram of an architecture of an electronic device to which a memory page processing method is applied according to an embodiment of this application;
FIG. 2 is a flowchart of a memory page processing method according to an embodiment of this application;
FIG. 3 is a diagram of an architecture of another electronic device to which a memory page processing method is applied according to an embodiment of this application;
FIG. 4 is a flowchart of another memory page processing method according to an embodiment of this application;
FIG. 5 is a diagram of accessing a memory by application programs according to an embodiment of this application;
FIG. 6 is a diagram of a structure of a memory page processing device according to an embodiment of this application;
FIG. 7 is a diagram of a structure of a memory padding apparatus according to an embodiment of this application; and
FIG. 8 is a diagram of a structure of another memory padding apparatus according to an embodiment of this application.

### DESCRIPTION OF EMBODIMENTS

For ease of understanding of specific implementations of this application, some terms in the specific implementations are described below.

Memory page: A memory space is divided into partitions of an equal size. Each partition is a memory page. Each memory page is represented by a physical page number. Physical page numbers of different memory pages are different. The memory page is also referred to as a physical block or a page frame.

Virtual page: A virtual address space of an application program is divided into areas of an equal size. A size of each area is equal to a size of a memory page. Each area is a virtual page. Each virtual page is represented by a virtual page number. Virtual page numbers of different virtual pages are different. The virtual page is also referred to as a page or a page.

A page table includes a plurality of page table entries (page table entries, PTEs). Each PPE includes a virtual page number of one virtual page, a physical page number of one physical page, and a valid flag, to indicate that the virtual page is mapped to a memory page (that is, whether the virtual page is invoked to the memory page). A value of the valid flag indicates whether a mapping relationship between the virtual page and the physical page is valid (that is, indicates whether the PTE is valid). For example, the value of the valid flag is 1, indicating that the mapping relationship is valid, and the virtual page has been invoked to the memory page; or the value of the valid flag is 0, indicating that the mapping relationship is invalid, and the virtual page is not invoked to the memory page.

Page fault: When an application program accesses a virtual page, a memory management unit (memory management unit, MMU) queries a page table to determine whether the virtual page to be accessed has been invoked to a memory page. Each time the virtual page is not invoked to the memory page, a page fault is generated. An operating system allocates a memory page to the virtual page from a memory applied for by the application program, and invokes the virtual page to the allocated memory page, to resolve the page fault.

A virtual address (virtual address, VA) is an address in a virtual address space. The virtual address space includes a plurality of virtual addresses. The virtual address includes a virtual page number of one virtual page and an intra-page offset. The intra-page offset indicates an address offset of the virtual address in the virtual page.

A physical address (physical address, PA) is an address in a physical address space. The physical address space is a space provided by a memory. The physical address space includes a plurality of physical addresses. The physical address includes a physical page number of one physical page and an intra-page offset. The intra-page offset indicates an address offset of the physical address in the memory page.

A cache compression algorithm is a data compression algorithm used when data (referred to as cache data) in a cache (cache) is migrated to a memory page. The cache compression algorithm defines at least one cache compression mode, a data compression manner of each cache compression mode, and a data sequence required by each cache compression mode. Different cache compression modes require different data sequences. The cache compression mode is a data compression mode used when the cache data is migrated to the memory page. When to-be-compressed cache data is the same as (that is, matches) a data sequence required by any cache compression mode, a cache compression solution of the cache compression mode may be used to compress the to-be-compressed cache data. If the to-be-compressed cache data is different from a data sequence required by the at least one cache compression mode, data compression cannot be performed on the to-be-compressed cache data. The data sequence required by the cache compression mode includes N (N>1) pieces of data, and the N pieces of data are N values in a same N-ary system. Therefore, the data sequence may also be referred to as a value sequence. A hexadecimal system is used as an example. Each of the N pieces of data is a value from a hexadecimal value 0 to value F. Then, a decimal system is used as an example. Each piece of data is a value from a decimal value 0 to value 9. The N pieces of data may be a same value, or may be different values. Each of the N pieces of data is stored in a form of binary data. During storage, each piece of data is represented by a binary value (0/1) of M (M>0) bits (bits). Using N=16 and M=4 as an example, one piece of hexadecimal data is represented by a binary value of 4 bits. During storage, a length of the data sequence is M*N bits.

FPC is a cache compression algorithm for performing compression/decompression based on a cache line (cache line). Each cache line is divided into 32-bit words (words). For example, a 64-byte cache line is 16 words, and each 32-bit word is encoded as a 3-bit prefix (prefix) plus data. Specifically, the FPC defines seven cache compression modes, such as a zero run (zero run) mode, a 4-bit sign-extended (4-bit sign-extended) mode, a 1-byte sign-extended (1-byte sign-extended) mode, a halfword sign-extended (halfword sign-extended) mode, a halfword padded with a zero halfword (halfword padded with a zero halfword) mode, a two halfword, each a byte sign-extended (two halfword, each a byte sign-extended) mode, and a word consisting of repeated bytes (word consisting of repeated bytes) mode. Each cache compression mode corresponds to a 3-bit prefix (prefix), and the prefix is a corresponding data compression manner. Using the zero run mode as an example, a prefix corresponding to zero run is 000, and a data sequence required by the zero run mode is a 32-bit word represented by a value 0. If the to-be-compressed cache data is a 32-bit word, and the cache data is 0x0000000000000000, the cache data matches the zero run mode, and the zero run mode is used to compress the cache data, to obtain compressed data 0x0, that is, the compressed data is 0-bit data plus a 3-bit prefix.

First data is data that is pre-padded by a memory padding apparatus in an empty memory page before an application program reads or writes data to the empty memory page. The empty memory page is a memory page to which no data is written.

A memory pre-padding function indicates to pad an empty memory page with first data before an application program accesses the empty memory page.

Next, an application environment of a memory page processing method provided in this application is described with reference to the accompanying drawings.

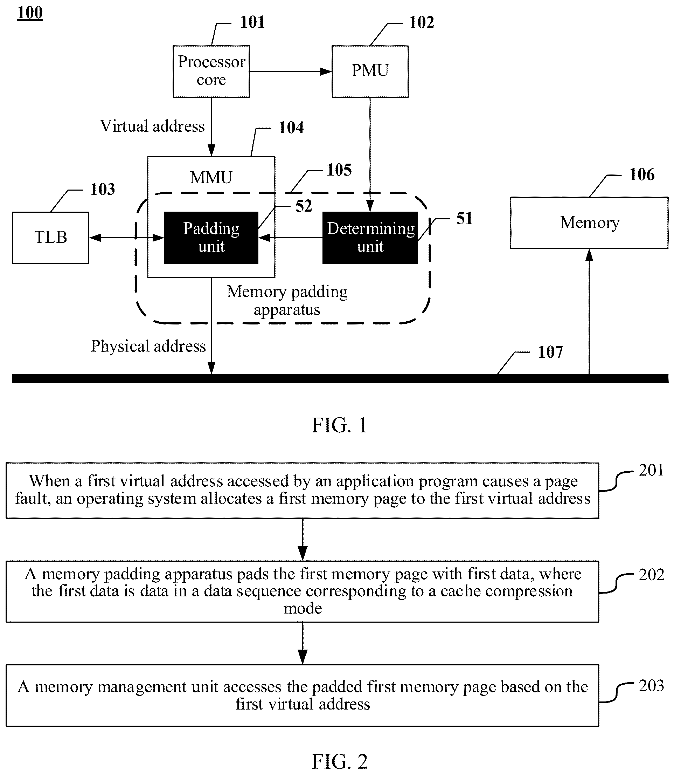

FIG. 1 is a diagram of an architecture of an electronic device to which a memory page processing method is applied according to an embodiment of this application. The electronic device 100 shown in FIG. 1 may be a terminal, a server, or a network device. A device type of the electronic device 100 is not limited in this embodiment of this application.

As shown in FIG. 1, the electronic device 100 includes a processor core (core) 101, a performance monitoring unit (performance monitoring unit, PMU) 102, an address translation lookaside buffer (translation lookaside buffer, TLB) 103, an MMU 104, a memory padding apparatus 105, a memory 106, and a bus 107. The processor core 101, the PMU 102, the MMU 104, and the TLB 103 are all integrated into a central processing unit (central processing unit, CPU). The CPU includes one or more processor cores 101. The CPU may further include a cache (cache). The cache is configured to cache data stored in the memory 106. The cache in the CPU may be a multi-level cache, for example, a level 1 cache to a level 3 cache, or a level 1 cache and a level 2 cache. A quantity of caches in the CPU and a level of the cache are not limited in this embodiment of this application. The MMU 104 communicates with the memory 106 through the bus 107, and the memory 106 is also referred to as a main memory (main memory).

The processor core 101 is configured to run an application program. One processor core 101 may run one or more application programs. In a process in which the processor core 101 runs the application program, the application program performs read/write access (that is, read access or write access) on a virtual page. The processor core 101 performs, by using the MMU 104, read/write access on a memory page, in the memory 106, corresponding to the virtual page, to complete the read/write access on the virtual page. The read access refers to reading data in the page, and the write access refers to writing data in the page.

The PMU 102 is a performance monitoring component embedded in the CPU, and is configured to collect statistics on a specific hardware event (referred to as a PMU event) that occurs in the CPU, for example, an event related to the processor core, an event related to the cache, and an event related to the TLB. The event related to the processor core is, for example, a quantity of executed instructions, a capture exception, a clock cycle, and a branch misprediction, the event related to the cache is, for example, a quantity of access times of caches at each level and a cache miss (cache miss), and the event related to the TLB 103 is, for example, a TLB miss (cache miss).

The TLB 103 is configured to cache a page table entry in a page table, where the page table is stored in the memory 106. The MMU 104 is a component configured to manage the memory 106, and the MMU 104 is also referred to as a memory management apparatus. The MMU 104 can translate a virtual address accessed by the application program into a physical address in the memory 106, and access the physical address. For example, in the process of running the application program, the processor core 101 delivers a virtual address to be accessed by the application program to the MMU 104, and the MMU 104 queries the page table entry cached in the TLB 103 for a virtual page number in the virtual address. If a PTE including the virtual page number is found, a TLB hit (hit) occurs. If no PTE including the virtual page number is found from the TLB 103, a TLB miss occurs. The MMU 104 queries the page table in the memory 106 for the PTE including the virtual page number, forms a physical address by using a physical page number in the found PTE and an address offset in the virtual address, to implement translation from the virtual address to the physical address, and performs read/write access on a location indicated by the physical address in the memory 106, to implement read/write access to the virtual address. In the process of running the application program, the MMU 104 migrates data frequently accessed by the application program in the memory 106 to a last level cache (last level cache, LLC) in the CPU. When a space in the LLC is insufficient, the MMC may evict cache data in at least one cache line in the LLC back to the memory 106. In a process of evicting the cache data to the memory 106, a cache compression algorithm may be used to migrate the cache data to the memory 106.

When the virtual page accessed by the application program is not invoked to the memory page, a page fault is triggered. For the page fault, an operating system invokes the virtual page to a memory page in the memory 106, and the invoked memory page is an empty memory page that is not padded with data. For the empty memory page, the memory padding apparatus 105 is configured to pre-pad the memory page with first data before the application program accesses the invoked virtual page. In this way, when the application program writes data to the virtual page subsequently, first data at a to-be-written location in the memory page may be updated to the to-be-written data. Optionally, before padding the memory page with the first data, the memory padding apparatus 105 may further first determine whether a memory pre-padding function is enabled for an application program to which the memory page belongs; and if the memory pre-padding function is enabled, pad the memory page with the first data; otherwise, skip padding the memory page with the first data. For example, the memory padding apparatus 105 may enable the memory pre-padding function for the application program based on a PMU event monitored by the PMU 102 in the process of running the application program. This process is subsequently described in detail with reference to a method embodiment.

The memory padding apparatus 105 may be implemented by using software, hardware, or a combination of software and hardware. The memory padding apparatus 105 is used as an example of a software functional unit. The memory padding apparatus 105 includes program code, and the processor core 101 implements a function of the memory padding apparatus 105 by running the program code.

The memory padding apparatus 105 is used as an example of a hardware functional unit. The memory padding apparatus 105 may be a device implemented by using an application-specific integrated circuit (application-specific integrated circuit, ASIC) or a programmable logic device (programmable logic device, PLD), or the like. The PLD may be implemented by using a complex programmable logical device (complex programmable logical device, CPLD), a field-programmable gate array (field-programmable gate array, FPGA), generic array logic (generic array logic, GAL), or any combination thereof.

When the memory padding apparatus 105 is used as the hardware functional unit, the memory padding apparatus 105 is integrated into the MMU 104, or is independent of the MMU 104. For example, the memory padding apparatus 105 is at a location other than the MMU 104 in the CPU, or is at a location other than the CPU in an electronic device in which the electronic device 100 is located. A location of the memory padding apparatus 105 is not limited in this embodiment of this application.

Optionally, as shown in FIG. 1, the memory padding apparatus 105 includes a determining unit 51 and a padding unit 52. It is preset in such a manner that the determining unit 51 is configured to determine whether the application program to which the memory page belongs enables the memory pre-padding function, and is further configured to enable the memory pre-padding function for the application program based on the PMU event monitored by the PMU 102 in the process of running the application program. The padding unit 52 is configured to pre-pad the memory page with the first data, or skip pre-padding the memory page with the first data based on a determining result of the determining unit 51. For any subunit of the determining unit 51 and the padding unit 52, the subunit may be implemented by using software, hardware, or a combination of software and hardware. For example, both the determining unit and the padding unit 52 are implemented by using hardware. As shown in FIG. 1, the padding unit 52 is integrated into the MMU 104, and the determining unit 51 is independent of the MMU 104. In some other embodiments, both the padding unit 52 and the determining unit 51 are integrated into the MMU 104 or are independent of the MMU 104.

Next, a process in which the memory padding apparatus pre-pads the memory page with the first data is described in detail with reference to FIG. 2.

FIG. 2 is a flowchart of a memory page processing method according to an embodiment of this application. The method is applied to an electronic device. The electronic device is, for example, the electronic device 100. The method is implemented by an operating system, a memory padding apparatus, and an MMU in the electronic device through interaction. The method includes the following steps.

201: When a first virtual address accessed by an application program causes a page fault, the operating system allocates a first memory page to the first virtual address.

The application program is any application program run by any processor core in any CPU of the electronic device. The application program corresponds to one virtual address space. The first virtual address is any virtual address in the virtual address space. For ease of description, a virtual page number in the first virtual address is referred to as a first virtual page number, a virtual page indicated by the first virtual page number is referred to as a first virtual page, and the first virtual page is a virtual page accessed by the application program. Allocating a memory page to the first virtual address is allocating a memory page to the first virtual page. Step 201 is: When the first virtual page accessed by the application program causes the page fault, the operating system allocates the memory page to the first virtual page, where the first memory page is a memory page allocated by the operating system to the first virtual page.

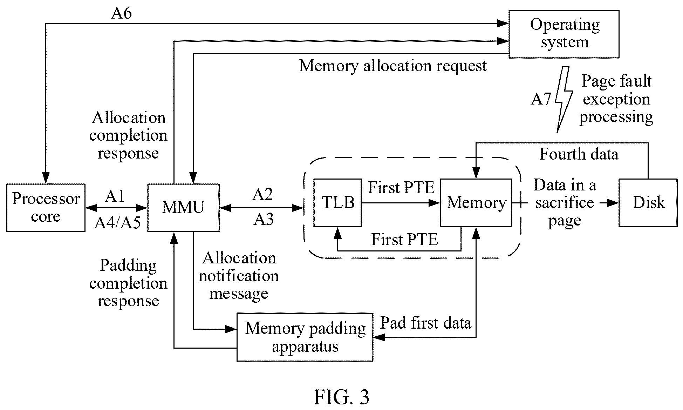

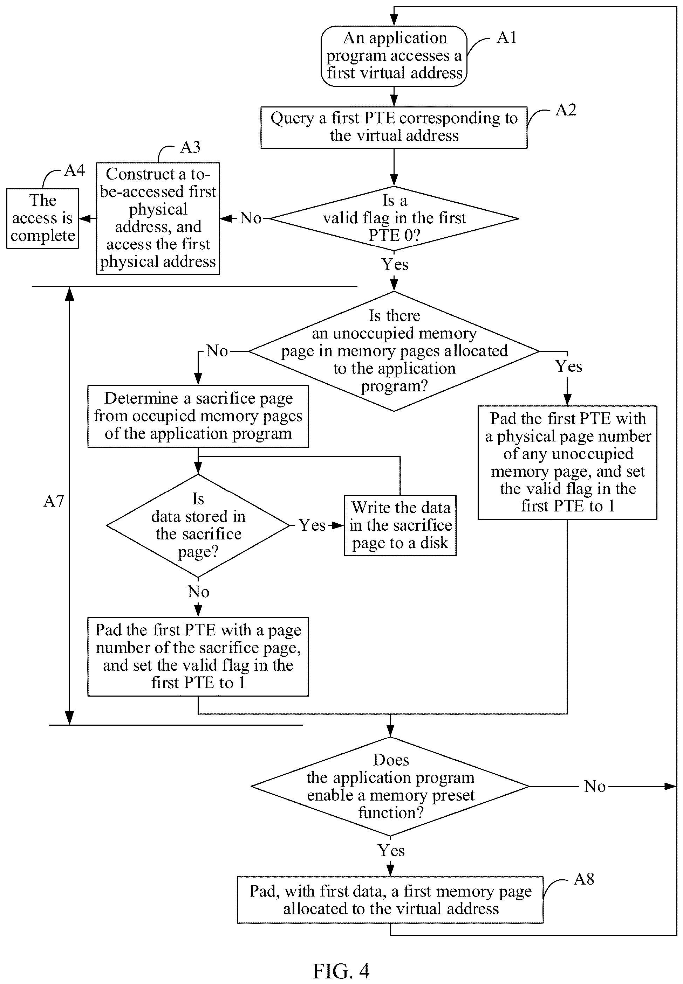

In a possible implementation, in a process in which the processing core in the electronic device runs the application program, if the page fault is caused due to access to the first virtual address, the processing core notifies the operating system that the page fault occurs, and the operating system allocates the memory page to the first virtual page, and invokes the first virtual page to the memory page, to end the page fault. Next, with reference to a diagram of an architecture of an electronic device shown in FIG. 3 and a flowchart of another memory page processing method shown in FIG. 4, a triggering process and a processing procedure of the page fault are described below.

Step A1: In the process of running the application program, the processor core sends a first read/write request to the MMU, where the first read/write request includes the first virtual address, to indicate to perform data read/write on the first virtual address.

Performing data read/write on the first virtual address is performing read/write access on the first virtual address. The first read/write request is a write request or a read request. When the first read/write request is the write request, the first read/write request further includes to-be-written data (referred to as second data). The first read/write request indicates to write the second data to the first virtual address. When the first read/write request is the read request, the first read/write request indicates to read data stored in the first virtual address.

For example, when the processor core executes any instruction (referred to as a first instruction) in the application program, the processor core sends the first read/write request to the MMU if there is a need to access the first virtual address.

Step A2: The MMU receives the first read/write request, and queries, based on the first read/write request, for a PTE (referred to as a first PTE) corresponding to the first virtual address, where the first PTE is a PTE that is in a page table and that includes the first virtual page number.

As shown in FIG. 3, the MMU first requests a TLB to query the first PTE. If the TLB finds the first PTE from a locally cached PTE, the TLB returns the first PTE to the MMU. If the first PTE is not found from the TLB, the MMU requests a memory to query the page table for the first PTE. If the first PTE is found from the page table in the memory, the memory returns the first PTE to the MMU. In this way, the MMU can find the first PTE from the TLB or the memory.

As shown in FIG. 3, if the TLB does not cache the first PTE and the page table includes the first PTE, as the application program is run, the MMU may further cache the first PTE in the page table in the TLB, so that the first PTE can be found from the TLB when the application program subsequently accesses the first virtual page again. After the first PTE is cached in the TLB, as the application program is run, the TLB may further evict the first PTE back to the page table.

After the first PTE is obtained, if a valid flag in the first PTE is not 0, for example, the valid flag in the first PTE is 1, the MMU is triggered to perform the following step A3 and step A4. If the valid flag in the first PTE is 0, the MMU jumps to perform the following step A5.

Step A3: When the valid flag in the first PTE is not 0, the MMU constructs a to-be-accessed first physical address based on the first PTE and the first virtual address, and accesses the first physical address in the memory.

The first physical address is a physical address corresponding to the first virtual address, that is, a physical address translated from the first virtual address, and the first virtual address is accessed by accessing the first physical address.

For example, the MMU combines a memory page number (referred to as a first memory page number) in the first PTE and an intra-page offset in the first virtual address, to obtain the first physical address. When the first read/write request is the read request, the MMU reads data (referred to as fourth data) stored in the first physical address in the first memory page, to access the first physical address. When the memory access request is the write request, the MMU writes the second data to the first physical address in the first memory page, to access the first physical address.

Step A4: The MMU sends a read/write completion response to the processor core, where the read/write completion response indicates that data read/write on the first virtual address is completed. In this case, a procedure of accessing the first virtual address ends.

When the first read/write request is the read request, the read/write completion response is a read completion response, indicating that data has been read from the first virtual address. In this case, the read/write completion response further includes the fourth data read from the first physical address. When the first read/write request is the write request, the read/write completion response is a write completion response, indicating that the second data has been written to the first virtual address.

Step A5: When the valid flag in the first PTE is 0, the MMU sends a read/write failure response to the processor core, where the read/write failure response indicates that reading/writing the first virtual address fails because there is no corresponding memory page.

Step A6: The processor core suspends the first instruction based on the read/write failure response, triggers the page fault, and sends a page fault notification message to the operating system, where the page fault notification message indicates that the page fault occurs when the first virtual page is accessed.

The page fault notification message includes the first virtual page number.

Step A7: The operating system receives the page fault notification message, and allocates the first memory page to the first virtual page based on the page fault notification message, to perform page fault exception processing.

As shown in FIG. 4, after receiving the page fault notification message, the operating system queries, in memory pages allocated to the application program, for whether there is an unoccupied memory page. The memory page allocated to the application program is a memory page in a memory space allocated by the operating system to the application program when the application program applies for memory. There are a plurality of memory pages allocated to the application program. The unoccupied memory page is a memory page that is not invoked to a virtual page, that is, a memory page for which no valid mapping relationship is established with the virtual page in the page table.

If there is an unoccupied memory page in the memory pages allocated to the application program, the operating system allocates any unoccupied memory page to the first virtual page. For example, as shown in FIG. 3, the operating system sends a first memory allocation request to the MMU, where the first memory allocation request includes the first virtual page number and a physical page number of the memory page, to indicate to allocate the memory page to the first virtual page. After receiving the first memory allocation request, the MMU queries for whether there is a valid PTE including the physical page number in the page table. Because the memory page is not occupied, the MMU finds no valid PTE including the physical page number, and the MMU continues to query the page table for the first PTE. As shown in FIG. 4, the MMU pads the first PTE with the physical page number of the memory page, and sets the valid flag in the first PTE to 1, so that the first PTE is valid, to indicate to allocate the memory page to the first virtual page, that is, to invoke the first virtual page to the memory page. In this case, the memory page is the first memory page.

If there is no unoccupied memory page in the memory pages allocated to the application program, in other words, all the memory pages allocated to the application program are occupied, the operating system determines, based on a memory page swap-in and swap-out mechanism, a sacrifice page from the occupied memory pages of the application program, and allocates the sacrifice page to the first virtual page. The sacrifice page is a memory page to be allocated to the first virtual page. For example, as shown in FIG. 3, the operating system sends a second memory allocation request to the MMU, where the second memory allocation request includes the first virtual page number and a physical page number of the sacrifice page, to indicate to allocate the sacrifice page to the first virtual page. After receiving the second memory allocation request, the MMU queries for whether there is a valid PTE including the physical page number in the page table, and a found valid PTE is referred to as a second PTE. Finding the second PTE indicates that the sacrifice page has been allocated to another virtual page other than the first virtual page. To avoid a data loss of the another virtual page, as shown in FIG. 3 and FIG. 4, the MMU queries for whether the sacrifice page stores data. If data is stored in the sacrificial page, for example, the data in the sacrifice page is written to a disk (disk) of the electronic device, the sacrifice page becomes an empty memory page. If no data is stored in the sacrifice page, the sacrifice page is an empty memory page. When the sacrifice page is an empty memory page, the MMU sets a valid flag in the second PTE to 0, to invalidate the second PTE, queries the page table for the first PTE, pads the first PTE with the physical page number of the sacrifice page, and sets the valid flag in the first PTE to 1, so that the first PTE is valid, to indicate to allocate the sacrifice page to the first virtual page, that is, to invoke the first virtual page to the sacrifice page. In this case, the sacrifice page is the first memory page.

The foregoing is described by using an example in which the page table includes the invalid first PTE when the application program accesses the first virtual page. In some other embodiments, when the application program accesses the first virtual page, the MMU may not find the first PTE from the page table. In this case, the MMU still sends a read/write failure response to the processor core, triggers the page fault, and triggers the operating system to allocate the first memory page to the first virtual page. In this case, after the MMU determines the first memory page (for example, a sacrifice page or any unoccupied memory page) to be allocated to the first virtual page, the MMU creates a valid first PTE in the page table based on the first virtual page number and a physical page number (referred to as a first physical page number) of the first memory page.

As shown in FIG. 3, after the first PTE is valid, the MMU sends an allocation notification message to the memory padding apparatus, where the allocation notification message is used to notify that the first memory page has been allocated to the first virtual page, that is, is used to notify that the first memory page has been allocated to the first virtual address for the page fault caused by access of the application program to the first virtual address. After receiving the allocation notification message, a memory allocation unit performs the following step 202 based on the allocation notification message. The allocation notification message includes the first virtual page number and the first physical page number.

202: The memory padding apparatus pads the first memory page with first data, where the first data is data in a data sequence corresponding to a cache compression mode, and the cache compression mode is a data compression mode used when data written by the application program in a cache is migrated to the memory page.

The cache compression mode is a cache compression mode defined in a cache compression algorithm used by the MMU. For example, the cache compression algorithm is FPC or another cache compression technology depending on the cache compression mode. The cache compression algorithm defines at least one cache compression mode, and a data sequence and a data compression manner that correspond to each cache compression mode. The data sequence corresponding to each cache compression mode is a data sequence required by each cache compression mode for to-be-compressed data.

The first data is data in a data sequence corresponding to any one of the at least one cache compression mode. For example, the first data is all data in the data sequence (that is, each piece of data in the data sequence), or the first data is some data in the data sequence. For example, the first data is the some data in the data sequence. It is assumed that the data sequence includes N pieces of data, and the first data is S pieces of data that appear most frequently in the data sequence, where N is greater than 1, and S is greater than 0 and less than N. For example, S=1. An example in which the cache compression mode is a zero run mode in the FPC is used, and a hexadecimal value 0 is data that appears most frequently in a data sequence corresponding to the zero run mode. Then, an example in which the cache compression mode is a 1-byte sign-extended mode in the FPC is used, and data that appears most frequently in the 1-byte sign-extended mode is a hexadecimal value F. For another example, S=2, the data sequence is 0000FFFF, and the first data is 0 and F. Alternatively, the first data is R consecutive pieces of data in the data sequence. For example, the first R pieces of data in the data sequence are the first data, or the middle R pieces of data are the first data, or the last R pieces of data are the first data, where R is greater than 0 and less than N, and R and S may be the same or different. Values of R and S are not limited in this embodiment of this application.

In some other embodiments, the first data is data in a plurality of data sequences required by a plurality of data compression modes defined by the cache compression algorithm. For example, the first data is S pieces of data that appear most frequently in the plurality of data sequences, or the first data is data shared by the plurality of data sequences.

As shown in FIG. 3, after receiving the allocation notification message of the MMU, the memory padding apparatus learns, based on the first virtual page number and the first physical page number in the allocation notification message, that the MMU has allocated the first memory page to the first virtual page. In this case, the first memory page is an empty memory page, and the memory padding apparatus pads the first memory page with the first data. For example, the first memory page is fully padded with the first data, or some memory spaces of the first memory page are padded with the first data, and the remaining space is not padded with the first data (that is, the first memory page is not fully padded with the first data).

For example, the first memory page is fully padded with the first data. It is assumed that a size of the first memory page is 64 bytes (bytes), and 64 bytes=16*8*4 bits. If a size of the first data during storage is 4 bits, as shown in Table 1, the memory padding apparatus pads the first memory page with eight pieces of first data at an interval of 4 bytes (that is, 8*4 bits), to fully pad the first memory page with the first data. In this way, when the application program writes data to the first virtual page subsequently, the MMU updates first data at a to-be-written location in the first memory page to the to-be-written data.

**Table 1**

| Quantity of bytes | 4 bytes | 4 bytes | 4 bytes | 4 bytes |
|---|---|---|---|---|
| First memory page | Eight pieces of first data | Eight pieces of first data | Eight pieces of first data | Eight pieces of first data |
| | Eight pieces of first data | Eight pieces of first data | Eight pieces of first data | Eight pieces of first data |
| | Eight pieces of first data | Eight pieces of first data | Eight pieces of first data | Fight pieces of first data |
| | Eight pieces of first data | Eight pieces of first data | Eight pieces of first data | Eight pieces of first data |

As shown in FIG. 3, after the first memory page is padded with the first data, the memory padding apparatus sends a padding completion response to the MMU, where the padding completion response indicates that the first memory page has been padded with the first data. After receiving the padding completion response, the MMU sends an allocation completion response to the operating system, where the allocation completion response indicates that the first memory page has been allocated to the first virtual page. After receiving the allocation completion response, the operating system sends a page fault processing completion response to the processor core, to indicate that the page fault caused by the first virtual page has been processed. After receiving the fault processing completion response, the processor core ends the processing procedure of the page fault, releases the suspended first instruction, and re-executes the first instruction. Therefore, the application program can only sense that the page fault occurs, but cannot sense an action of pre-padding the first memory page with the first data.

When re-executing the first instruction, the processor core sends the first read/write request to the MMU. After receiving the first read/write request again, the MMU accesses the first memory page based on the first virtual address in the first read/write request (that is, the following step 203).

203: The memory management unit accesses the padded first memory page based on the first virtual address.

For example, if the first read/write request that is received again is a write request, where to be distinguished from another write request in the following descriptions, the first read/write request is referred to as a first write request, the MMU performs step A2 again to query a first PTE corresponding to the first virtual address. In this case, a valid flag in the first PTE is 1, that is, the first PTE is a valid PTE. The MMU constructs the first physical address based on the first PTE and the first virtual address, and writes the second data to a location (referred to as a first location) indicated by the first physical address in the first memory page, to write data to a location corresponding to the first virtual address in the first memory page. In this case, the first location may be padded with the first data, or may not be padded with the first data. If the first location is not padded with the first data, the MMU writes the second data to the first location, to complete access to the first physical address and the first virtual address. If the first location has been pre-padded with the first data, when the second data is written to the first location, the first data at the first location is updated to the second data, where a storage space occupied by the second data is greater than or equal to a storage space occupied by the first data. For example, the MMU writes, in an overwrite form, the second data to the first location that is in the first memory page and that is indicated by the first physical address, so that the first data at the first location is updated to the second data, to complete access to the first physical address and the first virtual address.

Writing data to the first location means writing data starting from the first location. The foregoing Table 1 is still used as an example. It is assumed that the intra-page offset in the first physical address is 0, and the first location indicated by the first physical address is a start location of the first memory page. If a size of the second data is 4 bytes, as shown in Table 2, the MMU updates the first data stored in the first 4 bytes in the first memory page to the second data.

**Table 2**

| Quantity of bytes | 4 bytes | 4 bytes | 4 bytes | 4 bytes |
|---|---|---|---|---|
| First memory page | Second data | Eight pieces of first data | Eight pieces of first data | Eight pieces of first data |
| | Eight pieces of first data | Eight pieces of first data | Eight pieces of first data | Eight pieces of first data |
| | Eight pieces of first data | Eight pieces of first data | Eight pieces of first data | Eight pieces of first data |
| | Eight pieces of first data | Eight pieces of first data | Eight pieces of first data | Eight pieces of first data |

It is assumed that the first read/write request is a read request. In this case, the first memory page is pre-padded with the first data, which is not data to be read by the application program. The data to be read by the application program has not been loaded to the first memory page. As shown in FIG. 3, to enable the application program to read required fourth data, the MMU first writes the fourth data stored in the disk to the first physical address in the first memory page, to update the first data at the first physical address to the fourth data. Then, the application program reads the fourth data from the first physical address, to complete access to the first physical address and the first virtual address.

After completing access to the first physical address, access to the first memory page is implemented this time, and the MMU returns a read/write completion response to the processor core (that is, the foregoing step A4 is performed).

After the processing core receives the read/write completion response, the processor core continues to execute the first instruction or another instruction (referred to as a second instruction) of the application program other than the first instruction. In a process of continuing to execute the first instruction or the second instruction, the application program accesses the first virtual page or another virtual page other than the first virtual page. When accessing the first virtual page, the application program may access the another virtual address other than the first virtual address in the first virtual page, or access the first virtual address again. For a process of accessing the another virtual address in the first virtual page, refer to a process of accessing the first virtual address. Details are not described herein again. For a process of accessing the another virtual page, refer to a process of accessing the first virtual page. Details are not described herein again.

In a process in which the processor core runs the application program, the application program may access the first virtual page for a plurality of times. For write access performed by the application program on any virtual address in the first virtual page, the MMU updates first data at a location corresponding to the virtual address in the first memory page to the to-be-written data. If the application program frequently accesses at least one virtual address in the first virtual page in the running process, the MMU migrates data in a target memory space in which the at least one virtual address in the first memory page is located to a cache line (referred to as a first cache line) in a cache (for example, an LLC). The at least one virtual address may include the first virtual address, or may not include the first virtual address. A size of the target memory space is the same as a size of the cache line. The size of the target memory space may be the same as the size of the memory page, or may be different from the size of the memory page. When the size of the target memory space is the same as the size of the memory page, the target memory space is the first memory page, and all data stored in the first memory page needs to be migrated to the first cache line.

For ease of description, the data in the target memory space (that is, the data migrated to the cache) is referred to as first migrated data. As the application program accesses the target memory space, the first migrated data includes the first data and/or the data written by the application program. Table 2 is used as an example. It is assumed that the size of the cache line is the same as the size of the memory page, and both are 64 bytes. The application program frequently accesses the first memory page shown in Table 2. In this case, the first memory page is the target memory space, and the second data stored in the first memory page and each piece of first data form the first migrated data. The MMU migrates the first migrated data to the first cache line in the cache, and caches the first PTE in the page table in the TLB.

After the first migrated data is migrated to the first cache line, when the application program performs read access on the first virtual page, the MMU returns to-be-read data in the first cache line to the application program, to implement read access on the first memory page and the first virtual page. When the application program performs write access on the first virtual page, the MMU writes data to the first cache line, to implement write access on the first memory page and the first virtual page. In this case, the first migrated data is updated, and updated first migrated data is referred to as second migrated data.

An example in which the application program accesses the first virtual address is still used. The processor core delivers an indication, namely, the first read/write request, to the MMU, and the MMU may find the first PTE from the TLB based on the first virtual address in the first read/write request, construct the first physical address based on the first PTE and the first virtual address, and perform read access or write access on a location corresponding to the first physical address in the first cache line. The write access is used as an example. The to-be-written data is referred to as fifth data. The MMU writes, in an overwrite form, the fifth data to the location (referred to as a second location) corresponding to the first physical address in the first cache line, so that the data at the second location is updated to the fifth data, and then the first migrated data in the first cache line is updated to the second migrated data. The data at the second location may be the first data or may not be the first data. An example in which the first migrated data is the data shown in Table 2 is still used. It is assumed that the second location is a first bit of a 9^{th} byte in the first memory page. If the fifth data is 4 bytes, as shown in Table 3, after the fifth data is written to the first cache line, the fifth data may overwrite eight pieces of first data of the 9^{th} byte to a 12^{th} byte in the first memory page in the first cache line. It is assumed that the second location is a first bit of a 13^{th} byte in the first memory page. If the fifth data is 2 bytes, as shown in Table 3, after the fifth data is written to the first cache line, the fifth data may overwrite four pieces of first data of the 9^{th} byte and a 10^{th} byte in the first memory page in the first cache line.

**Table 3**

| Quantity of bytes | 4 bytes | 4 bytes | 4 bytes | 4 bytes |
|---|---|---|---|---|
| First cache line | Second data | Eight pieces of first data | Fifth data | Eight pieces of first data |
| | Fifth data plus four pieces of first data | Eight pieces of first data | Eight pieces of first data | Eight pieces of first data |
| | Eight pieces of first data | Eight pieces of first data | Eight pieces of first data | Eight pieces of first data |

Subsequently, when cache data (the first migrated data or the second migrated data) in the first cache line meets an eviction condition, the MMU migrates the cache data to the first memory page. The eviction condition is a condition for evicting the cache data in the cache line to the memory. It is assumed that a data sequence length required by the cache compression mode is M*N bits, and a size of a storage space of the first cache line is K bits, where K is greater than M*N. In this case, K/(M*N) pieces of to-be-migrated data are stored in the first cache line. Table 3 is still used as an example. K=64 bytes, and M*N=4 bytes. In this case, 16 pieces of to-be-migrated data are stored in the first cache line. For example, the second data is one piece of to-be-migrated data, eight pieces of first data are one piece of to-be-migrated data, 4-byte fifth data is one piece of to-be-migrated data, and 2-byte fifth data and four pieces of first data are one piece of to-be-migrated data.

When migrating the cache data in the first cache line to the first memory page, for each piece of to-be-migrated data, the MMU matches the to-be-migrated data with a data sequence required by the at least one cache compression mode. If the to-be-migrated data is the same as a data sequence required by any cache compression mode, the to-be-migrated data matches the data sequence and matches the cache compression mode; otherwise, the to-be-migrated data does not match the cache compression mode. If the to-be-migrated data matches the cache compression mode, the MMU compresses the to-be-migrated data in a data compression manner corresponding to the cache compression mode, to obtain compressed data, and writes the compressed data to the first memory page, to migrate the to-be-migrated data to the first memory page. If the to-be-migrated data does not match any cache compression mode, the MMU writes the to-be-migrated data to the first memory page, to migrate the to-be-migrated data to the first memory page.

As shown in Table 3, the to-be-migrated data may be the first data, or may be a combination (referred to as combined data) of the fifth data and some first data, or may be the fifth data. If the first data is data in a cache compression mode in the cache compression algorithm, when the to-be-migrated data is the first data or the combined data, compared with random data, the to-be-migrated data is more likely to match the cache compression mode, so that a probability that the to-be-migrated data is compressed can be increased. In this way, a compression ratio of the cache data when data is evicted from the cache to the memory can be increased. For example, the first data is a hexadecimal value 0, the to-be-migrated data is eight values 0, and the cache compression mode is the zero run mode in the FPC. Compared with the random data, the to-be-migrated data can definitely match the zero run mode. If the first data is data in a plurality of data sequences in a plurality of cache compression modes defined by the cache compression algorithm, for example, S pieces of data that appear most frequently in the plurality of data sequences or data shared by the plurality of data sequences, when the to-be-migrated data is the first data or the combined data, compared with random data, the to-be-migrated data is more likely to match the cache compression mode in the plurality of cache compression modes, so that a probability that the to-be-migrated data matches the cache compression mode can be further increased, a probability that the to-be-migrated data is compressed is further increased, and a compression ratio of the cache data when data is evicted from the cache to the memory can be further increased. The first data is a hexadecimal value 0. The value 0 appears in data sequences corresponding to a plurality of data cache modes, such as a zero run mode, a 4-bit sign-extended mode, a halfword sign-extended mode, and a halfword padded with a zero halfword mode, in the FPC. If the to-be-migrated data is eight values 0, the to-be-migrated data may match the zero run mode. If the to-be-migrated data is a combination of a plurality of values 0 and other values, the to-be-migrated data may match the 4-bit sign-extended mode, the halfword sign-extended mode, or the halfword padded with a zero halfword mode.

According to the method provided in this embodiment of this application, after a memory page is allocated to a virtual address that causes a page fault, the allocated memory page is pre-padded with first data, and then the memory page padded with the first data is accessed. Subsequently, if data in the memory page is migrated to a cache, the first data padded in the memory page is also migrated to the cache. If the data in the memory page is evicted from the cache to a memory, the evicted cache data may also include the first data. Because the first data is data in a data sequence corresponding to a cache compression mode, when the cache data including the first data is evicted back to the memory, a probability that the cache data matches the cache compression mode can be increased. In this way, a compression ratio of the cache data can be increased, and overheads of transmitting the cache data from the cache to the memory can be reduced.

The embodiment shown in FIG. 2 is described by using an example in which after the operating system allocates the first memory page to the first virtual page, the memory padding apparatus pads the first memory page with the first data. In another possible implementation, as shown in FIG. 4, before padding the first memory page with the first data, the memory padding apparatus further first determines whether the application program accessing the first virtual page enables a memory pre-padding function. When the application program does not enable the memory pre-padding function unit, the memory padding apparatus does not perform the step of padding the first memory page with the first data, and returns a padding failure response to the MMU, to indicate that the first memory page is not padded with the first data. As shown in step A8 in FIG. 4, the memory pre-padding function is enabled in the application program, and the memory padding apparatus pads, with the first data, the first memory page allocated to the virtual address, and returns the padding completion response to the MMU. In this way, after sending the allocation notification message to the memory padding apparatus, the MMU receives the padding failure response or the padding completion response of the memory padding apparatus, and then returns the allocation completion response to the operating system, so that the operating system sends the page fault processing completion response to the processor core, and the processor core performs step A1 again. In some other embodiments, when the first memory page is not padded with the first data, the memory padding apparatus may not return the padding failure response to the MMU. When the first memory page is padded with the first data, the memory padding apparatus may not return the padding completion response to the MMU. In this case, after sending the allocation notification message to the memory padding apparatus, the MMU returns the fault processing completion response to the operating system after specific duration, to reserve time for the memory padding apparatus to pad with the first data.

For the implementation in FIG. 4, the memory padding apparatus pre-pads, with the first data, a memory page allocated to the application program only when the application program enables the memory pre-padding function, and there is no need to pre-pad, with the first data, a memory page allocated to each application program run in the electronic device, to reduce a workload of the memory padding apparatus.

Next, a process of determining whether the application program enables the memory pre-padding function in a manner of enabling the memory pre-padding function for the application program is described below.

In a possible manner, the memory padding apparatus enables the memory pre-padding function for the application program in the following enabling manner 1 or enabling manner 2.

Enabling manner 1: When a type of the application program is a target type, the memory padding apparatus enables the memory pre-padding function for the application program.

The cache compression mode is applicable to an application program of the target type, for example, a compiler, an application program configured to simulate a discrete event, or an application program configured to process big data. The cache compression mode is not applicable to an application program of a non-target type, for example, a compression application program configured to compress data, or an application program for scientific computing.

Before the application program is run or in the process of running the application program, the memory padding apparatus queries for a program type of the application program from configuration information of the application program in the operating system. When the program type of the application program is the target type, the memory padding apparatus enables the memory pre-padding function for the application program. When the program type of the application program is not the target type, the memory padding apparatus does not enable the memory pre-padding function for the application program. The enabling manner is, for example, adding a preset function enabling identifier to the configuration information, where the preset function enabling identifier indicates that the application program enables the memory pre-padding function.

In another possible implementation, the memory padding apparatus is not responsible for enabling the memory pre-padding function for the application program, and the operating system enables the memory pre-padding function for the application program of the target type in a similar manner. Alternatively, neither the memory padding apparatus nor the operating system actively enables the memory pre-padding function for the application program. The operating system adds, only when a user delivers an instruction for enabling the memory pre-padding function for the application program, a preset function enabling identifier to configuration information of the application program according to the instruction of the user, to enable the memory pre-padding function for the application program.

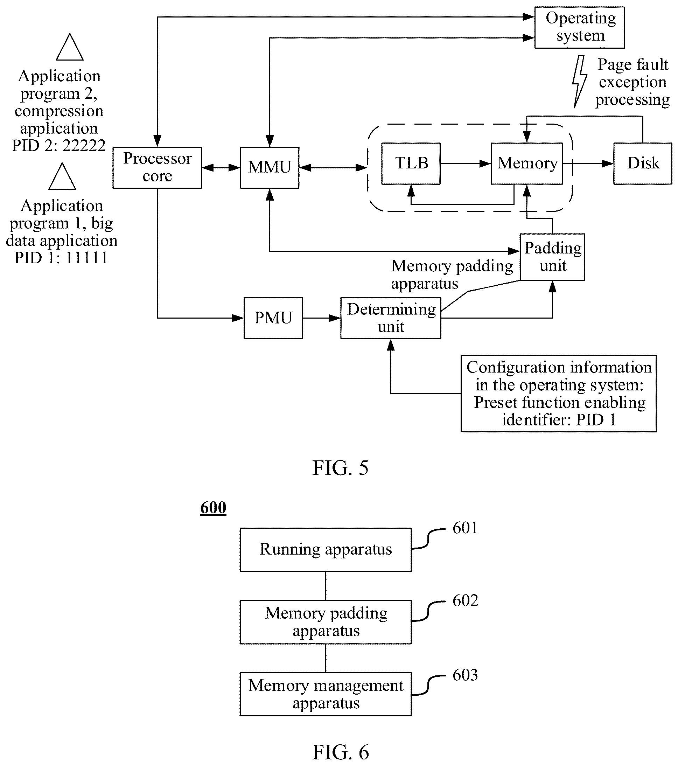

For the foregoing enabling manner 1, before padding any memory page with the first data, the memory padding apparatus determines, by querying for whether configuration information of an application program accessing the memory page includes the preset function enabling identifier, whether the application program enables the memory pre-padding function. A diagram of accessing a memory by application programs shown in FIG. 5 is used as an example. It is assumed that a processing core runs a process 1 and a process 2. Process identifiers (PIDs) of the process 1 and the process 2 are respectively 11111 and 22222. The process 1 and the process 2 correspond to an application program 1 and an application program 2 respectively. The application program 1 is a big data application, to which a cache compression mode is applicable, and enables a memory pre-padding function. The application program 2 is a compression application, to which a cache compression mode is not applicable, and does not enable the memory pre-padding function. The processor core runs the process 1 and the process 2, to run the application program 1 and the application program 2. It is assumed that both a virtual page 1 accessed by the process 1 and a virtual page 2 accessed by the process 2 trigger a page fault. After creating valid PTEs for the virtual page 1 and the virtual page 2, an MMU notifies a padding unit in a memory padding apparatus that memory pages have been allocated to the virtual page 1 and the virtual page 2. The memory padding apparatus sends a determining request to a determining unit based on the notification of the MMU, to request to determine whether the application programs corresponding to the process 1 and the process 2 enable the memory pre-padding function. After receiving the determining request, the determining unit queries for configuration information of the application program 1 and configuration information of the application program 1, finds a preset function enabling identifier from the configuration information of the application program 2, and finds, from the configuration information of the application program 1, that the preset function enabling identifier corresponds to the PID 1 of the process 1. In this case, the determining unit returns a determining response to the padding unit, to indicate that the application program 2 corresponding to the process 2 does not enable the memory pre-padding function and the application program 1 corresponding to the process 1 enables the memory pre-padding function. After receiving the determining response, the memory presetting module pads, with first data based on an indication of the determining response, the memory page allocated to the virtual page 1, and does not pad, with the first data, the memory page allocated to the virtual page 2.

Even if a memory page allocated to an application program to which the cache compression mode is not applicable is pre-padded with the first data, data of the application program cannot well match the cache compression mode when being migrated from a cache to a memory. Therefore, in the foregoing enabling manner 1, the memory padding apparatus enables the memory pre-padding function for the application program only when the cache compression mode is applicable to the application program, so that in the process of running the application program, the memory page of the application program is pre-padded with the first data, to improve compression efficiency when the data of the application program is migrated from the cache to the memory, and further avoid padding, with the first data, the memory page of the application program to which the cache compression mode is not applicable, to reduce a workload of the memory padding apparatus.

Enabling manner 2: In the process of running the application program, the memory padding apparatus periodically enables the memory pre-padding function for the application program based on a running status of the application program.

The running status of the application program is reflected by a first PMU event and/or a second PMU event that are/is triggered in the process of running the application program. The first PMU event is that a floating-point operation instruction is executed when the application program is run, and the floating-point operation instruction is an instruction used for a floating-point operation.

The second PMU event is a PMU event related to data exchange between the cache and the memory. The second PMU event can reflect a status of data exchange between the cache and the memory in the process of running the application program. There is at least one second PMU event, for example, a cache miss event, a TLB miss event, or a pipeline stall event due to a quantity of level 1/level 2 cache misses (core_pipeline_stall_due_to_cache_miss).

In a possible implementation, in the process of running the application program, after each time period, the memory padding apparatus predicts, based on a running status of the application program in the time period, whether the cache compression mode is applicable to the application program when the application program is run in a next time period, and if the cache compression mode is applicable, enables the memory pre-padding function for the application program in the next time period; otherwise, skips performing the step of enabling the memory pre-padding function for the application program in the next time period. Duration of the time period is the same as duration of the next time period, and the duration of the time period is unit duration for enabling the memory pre-padding function.

FIG. 5 is used as an example. In the process in which the processor core runs the application program, a PMU records and collects statistics on the first PMU event and/or the second PMU event triggered by the application program. The determining unit in the memory padding apparatus obtains, after each time period, statistical information of the first PMU event and/or the second PMU event in the time period from the PMU, and predicts, based on the statistical information, whether the cache compression mode is applicable to the application program when the application program is run in a next time period.

For example, obtaining the statistical information of the first PMU event in the time period is used as an example. The statistical information of the first PMU event in the time period is a quantity of floating-point operation instructions run in the time period. The determining unit further obtains, from the PMU, a total quantity of instructions of the application program run in the time period, and obtains, based on the quantity of floating-point operation instructions and the total quantity of instructions, a proportion of the floating-point operation instructions in the instructions of the application program run in the time period. The proportion is a ratio of the quantity of floating-point operation instructions to the total quantity of instructions. The cache compression mode is applicable to non-floating-point data (for example, integer data), and is not applicable to floating-point data. If the proportion is less than or equal to a proportion threshold, it indicates that the cache compression mode is applicable to the application program, and the determining unit enables the memory pre-padding function for the application program in the next time period. If the proportion is greater than the proportion threshold, it indicates that the cache compression mode is not applicable to the application program, and the determining unit temporarily does not enable the memory pre-padding function for the application program.

Obtaining the statistical information of the second PMU event is used as an example. The statistical information of the second PMU event is used as an example. It is assumed that at least one of the cache miss event, the TLB miss event, and the pipeline stall event due to a quantity of level 1/level 2 cache misses is a second PMU event. Statistical information of the cache miss event in the time period is a quantity of occurrences (referred to as a first quantity of occurrences) of the cache miss event in the time period. If the first quantity of occurrences is greater than or equal to a first quantity-of-times threshold, it indicates that data is frequently exchanged between the cache and the memory in the time period. If the first quantity of occurrences is less than the first quantity-of-times threshold, it indicates that data is not frequently exchanged between the cache and the memory in the time period. Statistical information of the TLB miss event in the time period is a quantity of occurrences (referred to as a second quantity of occurrences) of the TLB miss event in the time period. If the second quantity of occurrences is greater than or equal to a second quantity-of-times threshold, it indicates that data is frequently exchanged between the cache and the memory in the time period. If the second quantity of occurrences is less than the first quantity-of-times threshold, it indicates that data is not frequently exchanged between the cache and the memory in the time period. Statistical information of the pipeline stall event in the time period is total pipeline stall duration (pipeline stall) due to the pipeline stall event in the time period. If the pipeline stall is greater than or equal to a duration threshold, it indicates that data is frequently exchanged between the cache and the memory in the time period. If the pipeline stall is less than the duration threshold, it indicates that data is not frequently exchanged between the cache and the memory in the time period. If data is frequently exchanged between the cache and the memory in the time period, it indicates that the cache compression mode is applicable to the application program when the application program is run in the time period, and the cache compression mode is also likely to be applicable to the application program when the application program is run in the next time period. If data is not frequently exchanged between the cache and the memory in the time period, it indicates that the cache compression mode is not applicable to the application program when the application program is run in the time period, and the cache compression mode is unlikely to be applicable to the application program when the application program is run in the next time period. In view of this, if the first quantity of occurrences is less than the first quantity-of-times threshold, the second quantity of occurrences is less than the second times quantity threshold, and the pipeline stall is less than the duration threshold, the cache compression mode is not applicable to the application program when the application program is run in the next time period, and the determining unit temporarily does not enable the memory pre-padding function for the application program. If the first quantity of occurrences, the second quantity of occurrences, and the pipeline stall meet at least one of the following: the first quantity of occurrences is greater than or equal to the first quantity-of-times threshold, the second quantity of occurrences is greater than or equal to the second times quantity threshold, and the pipeline stall is greater than or equal to the duration threshold, the cache compression mode is applicable to the application program when the application program is run in the next time period, and the determining unit enables the memory pre-padding function in the next time period for the application program.

In some other embodiments, it is preset in such a manner that a submodule does not obtain the statistical information of the first PMU event in the time period, obtains the statistical information of the second PMU event, and determines, based only on the statistical information of the second PMU event, whether the memory pre-padding function needs to be enabled for the application program in the next time period.

In some other embodiments, the determining unit may alternatively input the statistical information of the first PMU event and/or the statistical information of the first PMU event in the time period into an artificial intelligence (artificial intelligence, AI) model. The AI model outputs a determining result based on the statistical information of the first PMU event and/or the statistical information of the first PMU event in the time period, where the determining result indicates whether the memory pre-padding function needs to be enabled for the application program in the next time period. The threshold determining submodule enables, based on an indication of the determining result, the memory pre-padding function for the application program in the next time period, or temporarily does not enable the memory pre-padding function for the application program in the next time period. The AI model is obtained through training based on statistical information of a plurality of pieces of first training data and a plurality of pieces of second training data, where the first training data is statistical information of a first PMU event and/or a second PMU event triggered in a process of running the application program of the target type, and the second training data is statistical information of a first PMU event and/or a second PMU event triggered in a process of running the application program of the non-target type, so that the AI model can learn, in a training process, a mapping relationship between the statistical information of the first PMU event and/or the second PMU event and whether the memory pre-padding function needs to be enabled for the application program in the next time period. The AI model may be a decision tree model or another type of AI model.

Obtaining the statistical information of the first PMU event and the second PMU event in the time period is used as an example. If it is determined, based on the statistical information of the first PMU event, that the cache compression mode is not applicable to the application program when the application program is run in the next time period, the determining unit determines, based on the statistical information of the second PMU event, whether to enable the memory pre-padding function for the application program in the next time period. If it is determined, based on the statistical information of the first PMU event, that the cache compression mode is applicable to the application program when the application program is run in the next time period, the determining unit does not need to perform further determining based on the statistical information of the second PMU event. In some other embodiments, the determining logic is implemented by using a decision tree. When in use, the determining unit may input the statistical information of the first PMU event and the second PMU event in the time period into the decision tree, and the decision tree outputs a determining result based on the foregoing determining logic. The determining result indicates whether to enable the memory pre-padding function for the application program in the next time period.

In some other embodiments, the determining unit may alternatively input the statistical information of the first PMU event and/or the statistical information of the first PMU event in the time period into an artificial intelligence (artificial intelligence, AI) model. The AI model outputs a determining result based on the statistical information of the first PMU event and/or the statistical information of the first PMU event in the time period. The AI model is obtained through training based on statistical information of a plurality of pieces of first training data and a plurality of pieces of second training data, where the first training data is statistical information of a first PMU event and/or a second PMU event triggered in a process of running the application program of the target type, and the second training data is statistical information of a first PMU event and/or a second PMU event triggered in a process of running the application program of the non-target type, so that the AI model can learn, through training, a mapping relationship between the statistical information of the first PMU event and/or the second PMU event and the determining result. The AI mode is, for example, a neural network model.

If the determining unit determines to enable the memory pre-padding function for the application program in the next time period, the determining unit queries for whether the configuration information of the application program in the operating system includes the preset function enabling identifier, and if the configuration information does not include the preset function enabling identifier, adds the preset function enabling identifier to the configuration information; or if the configuration information includes the preset function enabling identifier, does not need to add the preset function enabling identifier. In this way, in the next time period, the determining unit may determine, based on the preset function enabling identifier in the configuration information, that the memory pre-padding function is enabled for the application program in the next time period.

If the determining unit determines not to enable the memory pre-padding function for the application program in the next time period, the determining unit queries for whether the configuration information of the application program in the operating system includes the preset function enabling identifier, and if the configuration information includes the preset function enabling identifier, deletes the preset function enabling identifier from the configuration information. In this way, in the next time period, the determining unit finds no preset function enabling identifier from the configuration information, so that the determining unit can determine that the memory pre-padding function is not enabled for the application program in the next time period.

The embodiment shown in FIG. 5 is described by using an example in which the memory padding apparatus includes the determining unit and the padding unit. In some other embodiments, the memory padding apparatus is not divided into subunits. In this case, steps performed by the determining unit and the padding unit are implemented by the memory padding apparatus.

Based on the foregoing enabling manner 2, in the process of running the application program, the memory pre-padding function may be periodically enabled for the application program, so that more refined control can be performed on whether to enable the memory padding function for the application program. In a time period in which the memory pre-padding function is not enabled, there is no need to pad, with the first data, an empty memory page to which the virtual page is invoked, to further reduce a workload of the memory padding apparatus.

In some other embodiments, the memory pre-padding unit does not have a capability of enabling the memory pre-padding function for the application program. In this case, the operating system or another unit may enable the memory pre-padding function for the application program based on the foregoing enabling manner 1 or enabling manner 2.

The embodiments in FIG. 2 to FIG. 5 are described by using an example in which the application program accesses one virtual page. In some other embodiments, a computing task of the application program may correspond to a plurality of virtual pages, and the plurality of virtual pages are consecutive. A plurality of memory pages corresponding to the plurality of virtual pages are used to store task data of the computing task. The task data is data generated in a process in which the application program is used to execute the computing task.

When the application program writes the task data, the task data may be written to all of the plurality of virtual pages, or the task data may be written to some of the plurality of virtual pages. When the data is written to some of the virtual pages, the virtual pages to which the task data is written may be adjacent or may not be adjacent. For example, the computing task corresponds to a virtual page 1 to a virtual page 3, and the virtual page 1 to the virtual page 3 are consecutive. It is assumed that when the computing task meets a condition 1, the application program writes the task data of the computing task to the virtual page 1; when the computing task meets a condition 2, the application program writes the task data of the computing task to the virtual page 2; and when the computing task meets a condition 3, the application program writes the task data of the computing task to the virtual page 3. When the application program executes the computing task, the computing task may not meet a condition in the condition 1 to the condition 3. As a result, the application program does not pad some of the virtual page 1 to the virtual page 3 with the task data. For example, in a process of executing the computing task, if only the condition 1 and the condition 3 are met, and the condition 2 is not met, the application program writes the task data to the virtual page 1 and the virtual page 3, and does not write the task data to the virtual page 2. In a related technology, the MMU writes the task data to a memory page 1 and a memory page 3 corresponding to the virtual page 1 and the virtual page 3, to write the task data to the virtual page 1 and the virtual page 3. Because the application program does not write the task data to the virtual page 2, the MMU pads an inner page 2 corresponding to the virtual page 2 with a random value. Once data in the memory page 1 to the memory page 3 is migrated to the cache, the random value padded in the memory page 2 is also migrated to the cache. When cache data in the memory page 1 to the memory page 3 in the cache is evicted back to the memory page, the random value in the cache data in the memory page 2 makes it difficult for the cache data to match a cache compression mode, resulting in a low cache compression ratio.

In this application, the memory padding unit pads each empty memory page of the application program with the first data. If a corresponding memory page is not padded with the task data of the computing task executed by the application program, because the memory page has been padded with the first data, the MMU does not continue to pad the memory page with a random value. Therefore, a problem of a low cache compression ratio caused by padding with the random value can be avoided.

For example, a computing task of the application program corresponds to a plurality of virtual pages (referred to as second virtual pages). A memory page corresponding to the second virtual page is referred to as a second memory page, and the plurality of second memory pages are all used to store task data of the computing task of the application program. According to a processing procedure of padding the first memory page with the first data (FIG. 2 or FIG. 4), when each second memory page is invoked to a corresponding second virtual page, the memory padding unit pads the second memory page with the first data, so that before writing the task data to each second memory page, the application program pre-pads each second memory page with the first data.

In a process in which the processor core executes the computing task of the application program, when the application program writes the task data to a second virtual address of any virtual address (referred to as a second virtual address) in the plurality of second virtual pages, the processor core is triggered to send a second write request of the application program to a memory management apparatus, where the second write request indicates to write the task data to the second virtual address. After receiving the second write request, the memory management apparatus translates the second virtual address in the second write request into a physical address (referred to as a second physical address). For a process of translating the address, refer to a process of translating the first virtual address into the first physical address. The memory management apparatus updates first data at the second physical address in the plurality of second memory pages to to-be-written task data, to update first data at a location corresponding to the second virtual address in the plurality of second memory pages to the task data. A second memory page in which the second physical address is located is referred to as a third memory page. When the task data is written to the second physical address in the third memory page, if data in the third memory page has not been migrated to a cache line (referred to as a second cache line) in the cache, the memory management apparatus writes the task data to the second physical address in the third memory page. If the data in the third memory page has been migrated to the second cache line, the memory management apparatus writes the task data to a location corresponding to the second physical address in the second cache line, to overwrite first data at the location. Subsequently, if cache data in the third memory page in the second cache line is evicted back to the third memory page, because the cache data includes the first data, the cache data matches a cache compression mode more easily, to increase a cache compression ratio.

After data in the plurality of second memory pages is migrated to the cache, the first data padded in the plurality of second memory pages and/or the task data written by the application program are/is migrated to the cache. For any memory page (referred to as a fourth memory page) other than the third memory page in the plurality of second memory pages, before the task data is written to the fourth memory page, data in the fourth memory page is the first data, and cache data in the fourth memory page in the cache is the second data. If the application program does not write the task data to the fourth memory page in a process of executing the computing task, the cache data in the fourth memory page in the cache is always the first data instead of a random value. When the cache data in the fourth memory page is subsequently evicted back to the fourth memory page, the cache data matches a cache compression mode more easily, to increase a cache compression ratio. If the application program subsequently writes the task data to the fourth memory page, the task data is written to the cache data in the fourth memory page in the cache, to overwrite some or all of the first data in the cache data. When the cache data in the fourth memory page is subsequently evicted back to the fourth memory page, if the cache data in the fourth memory page still includes the first data, the cache data matches a cache compression mode more easily, to increase a cache compression ratio.

The foregoing describes the methods in embodiments of this application. The following describes apparatuses and devices in embodiments of this application. It should be understood that the apparatuses and the devices described below have a same inventive concept as the foregoing method embodiments, and can achieve beneficial effects that can be achieved in the foregoing method embodiments. The following describes the apparatuses and the devices in embodiments of this application with reference to FIG. 6 to FIG. 8. It should be understood that the technical features described in the method embodiments are also applicable to the following apparatus embodiments and device embodiments.

FIG. 6 is a diagram of a structure of a memory page processing device according to an embodiment of this application. The device 600 shown in FIG. 6 may be an electronic device, for example, a terminal, a server, or a network device. A device type of the device 600 is not limited herein. As shown in FIG. 6, the device 600 includes:
a running apparatus 601, configured to: when a first virtual address accessed by an application program causes a page fault, allocate a first memory page to the first virtual address by running an operating system, where the running apparatus 601 is a module that runs the operating system in the device 600;
a memory padding apparatus 602, configured to pad the first memory page with first data, where the first data is data in a data sequence corresponding to a cache compression mode, and the cache compression mode is a data compression mode used when data written by the application program in a cache is migrated to the memory page; and
a memory management apparatus 603, configured to access the padded first memory page based on the first virtual address.

In a possible implementation, the memory padding apparatus 602 is further configured to:
pad the first memory page with the first data when the application program enables a memory pre-padding function, where the memory pre-padding function indicates to pad an empty memory page with the first data before the application program accesses the empty memory page.

In a possible implementation, the memory padding apparatus 602 is further configured to:
periodically enable, by the memory padding apparatus, the memory pre-padding function for the application program based on a running status of the application program; otherwise, skip performing the step of enabling the memory pre-padding function for the application program.

In a possible implementation, the memory padding apparatus 602 is further configured to:
when a type of the application program is a target type, enable the memory pre-padding function for the application program, where the cache compression mode is applicable to the application program of the target type.

In a possible implementation, the memory management apparatus 603 is configured to:
receive a first write request of the application program, where the first write request indicates to write second data to the first virtual address; and
update the first data at a location corresponding to the first virtual address in the first memory page to the second data.

In a possible implementation, a plurality of second memory pages are all used to store task data of a same computing task of the application program, the plurality of second memory pages are all padded with the first data, and the memory management apparatus 603 is further configured to:
receive a second write request of the application program, where the second write request indicates to write the task data to a second virtual address; and
update the first data at a location corresponding to the second virtual address in the plurality of second memory pages to the task data.

In a possible implementation, the first data is each piece of data in the data sequence; the first data is S pieces of data that appear most frequently in the data sequence, where S is greater than 0; or the first data is R consecutive pieces of data in the data sequence, where R is greater than 0.

In a possible implementation, the first data is S pieces of data that appear most frequently in a plurality of data sequences, where the plurality of data sequences correspond to different cache compression modes, and S is greater than 0; or the first data is data shared by the plurality of data sequences.

When the device 600 processes a memory page, division of the foregoing functional modules is merely used as an example for description. During actual application, the foregoing functions may be allocated to different functional modules for implementation according to a requirement. That is, an internal structure of the device 600 is divided into different functional modules, to implement all or some of the functions described above. In addition, the device 600 provided in the foregoing embodiment and the foregoing method embodiments have a same concept. For a specific implementation process of the device, refer to the foregoing method embodiments. Details are not described herein again.

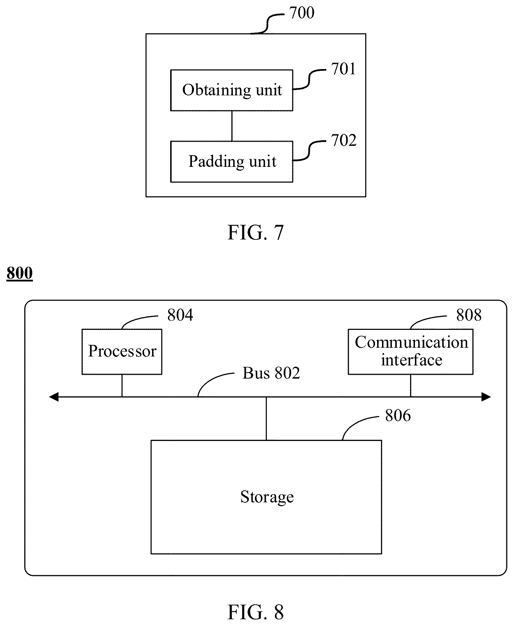

FIG. 7 is a diagram of a structure of a memory padding apparatus according to an embodiment of this application. As shown in FIG. 7, the apparatus 700 includes:
an obtaining unit 701, configured to obtain an allocation notification message, where the allocation notification message is used to notify that a first memory page has been allocated to a first virtual address for a page fault caused by access of an application program to the first virtual address; and
a padding unit 702, configured to pad the first memory page with first data, where the first data is data in a data sequence corresponding to a cache compression mode, and the cache compression mode is a data compression mode used when data written by the application program in a cache is migrated to the memory page.

In a possible implementation, the padding unit 702 is further configured to:
pad the first memory page with the first data when the application program enables a memory pre-padding function, where the memory pre-padding function indicates to pad an empty memory page with the first data before the application program accesses the empty memory page.

In a possible implementation, the apparatus 700 further includes:
an enabling unit, configured to periodically enable the memory pre-padding function for the application program based on a running status of the application program.

In a possible implementation, the apparatus 700 further includes:
an enabling unit, configured to: when a type of the application program is a target type, enable the memory pre-padding function for the application program, where the cache compression mode is applicable to the application program of the target type.

The enabling unit in the foregoing two implementations may be the determining unit in the memory padding apparatus described in the foregoing embodiment.

In a possible implementation, the first data is each piece of data in the data sequence; the first data is S pieces of data that appear most frequently in the data sequence, where S is greater than 0; or the first data is R consecutive pieces of data in the data sequence, where R is greater than 0.

In a possible implementation, the first data is S pieces of data that appear most frequently in a plurality of data sequences, where the plurality of data sequences correspond to different cache compression modes, and S is greater than 0; or the first data is data shared by the plurality of data sequences.

It should be understood that when the apparatus 700 processes a memory page, division of the foregoing functional modules is merely used as an example for description. During actual application, the foregoing functions may be allocated to different functional modules for implementation according to a requirement. That is, an internal structure of the apparatus 700 is divided into different functional modules, to implement all or some of the functions described above. In addition, the apparatus 700 provided in the foregoing embodiment and the foregoing method embodiments have a same concept. For a specific implementation process of the apparatus, refer to the foregoing method embodiments. Details are not described herein again.

FIG. 8 is a diagram of a structure of another memory padding apparatus according to an embodiment of this application. As shown in FIG. 8, the memory padding apparatus 800 includes a bus 802, a processor 804, a storage 806, and a communication interface 808. The processor 804, the storage 806, and the communication interface 808 communicate with each other through the bus 802. The memory padding apparatus 800 may be a server or a client. It should be understood that a quantity of processors and a quantity of storages in the memory padding apparatus 800 are not limited in this application. The bus 802 may be a peripheral component interconnect (peripheral component interconnect, PCI) bus, an extended industry standard architecture (extended industry standard architecture, EISA) bus, or the like. Buses may be classified into an address bus, a data bus, a control bus, and the like. For ease of representation, only one line is used for representation in FIG. 8, but this does not mean that there is only one bus or only one type of bus. The bus 802 may include a path for information transmission between components (for example, the storage 806, the processor 804, and the communication interface 808) of the memory padding apparatus 800. The processor 804 may include any one or more of processors such as a central processing unit (central processing unit, CPU), a graphics processing unit (graphics processing unit, GPU), a microprocessor (microprocessor, MP), or a digital signal processor (digital signal processor, DSP). The storage 806 may include a volatile memory (volatile memory), for example, a random access memory (random access memory, RAM). The storage 806 may further include a non-volatile memory (non-volatile memory), for example, a read-only memory (read-only memory, ROM), a flash memory, a hard disk drive (hard disk drive, HDD), or a solid-state drive (solid-state drive, SSD). The storage 806 stores executable program code, and the processor 804 executes the executable program code, to enable the memory padding apparatus 800 to implement the memory page processing method. In a possible implementation, the memory padding apparatus 800 is a chip.

In an example embodiment, an electronic device is further provided. The electronic device includes a processor. The processor is configured to execute program code, to enable the electronic device to perform an operation performed for implementing a memory page processing method applied to the electronic device. For example, for a hardware structure of the electronic device, refer to the memory padding apparatus 800. A difference from the memory padding apparatus 800 is that program code stored in a storage in the electronic device is used to implement the memory page processing method applied to the electronic device.

In an example embodiment, a computer-readable storage medium, for example, a storage including program code, is further provided. The program code may be executed by the processor of the memory padding apparatus 800, to complete the memory page processing method in the foregoing embodiments. Alternatively, the program code is executed by the processor of the electronic device, to complete the memory page processing method applied to the electronic device in the foregoing embodiments. For example, the computer-readable storage medium is a non-transitory computer-readable storage medium, for example, a read-only memory (read-only memory, ROM), a random access memory (random access memory, RAM), a compact disc read-only memory (compact disc read-only memory, CD-ROM), a magnetic tape, a floppy disk, or an optical data storage device.

An embodiment of this application further provides a computer program product or a computer program. The computer program product or the computer program includes program code. Computer instructions are stored in a computer-readable storage medium. A processor of a memory padding apparatus reads the program code from the computer-readable storage medium. The processor executes the program code, to enable the memory padding apparatus to perform the memory page processing method in the foregoing embodiments. Alternatively, a processor of an electronic device reads the program code from the computer-readable storage medium. The processor executes the program code, to enable the electronic device to perform the memory page processing method in the foregoing embodiments.

The apparatus, the device, the computer-readable storage medium, the computer program product, and the chip provided in embodiments are all configured to perform the corresponding methods provided above. Therefore, for beneficial effects that can be achieved by the apparatus, the device, the computer-readable storage medium, the computer program product, and the chip, refer to the beneficial effects of the corresponding methods provided above. Details are not described herein again.

In the several embodiments provided in this application, it should be understood that the disclosed apparatus and method may be implemented in other manners. For example, the apparatus embodiment described above is merely an example. For example, division into modules or units is merely logical function division, and may be other division in an actual implementation. For example, a plurality of units or components may be combined or may be integrated into another apparatus, or some features may be ignored or not performed. In addition, the displayed or discussed mutual couplings or direct couplings or communication connections may be implemented through some interfaces. The indirect couplings or the communication connections between the apparatuses or units may be implemented in electronic, mechanical, or other forms.

The units described as separate parts may or may not be physically separate, and parts displayed as units may be one or more physical units, may be located in one place, or may be distributed in a plurality of different places. Some or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

The integrated unit may be stored in a readable storage medium when being implemented in the form of the software functional unit and sold or used as an independent product. Based on such an understanding, the technical solutions in embodiments of this application essentially, or a part contributing to the conventional technology, or all or some of the technical solutions may be implemented in a form of a software product. The software product is stored in a storage medium and includes several instructions for instructing a device (which may be a single-chip microcomputer, a chip, or the like) or a processor (processor) to perform all or some of the steps of the methods described in embodiments of this application. The foregoing storage medium includes any medium that can store program code, such as a USB flash drive, a removable hard disk drive, a ROM, a RAM, a magnetic disk, or an optical disc.

In descriptions of this application, unless otherwise specified, "/" means "or". For example, A/B may indicate A or B. The term "and/or" in this specification describes only an association relationship for describing associated objects and represents that three relationships may exist. For example, A and/or B may represent the following three cases: Only A exists, both A and B exist, and only B exists. In addition, "at least one" means one or more, and "a plurality of" means two or more. Terms such as "first" and "second" do not limit a quantity and an execution sequence, and the terms such as "first" and "second" do not indicate a definite difference.

In this application, the terms such as "example" or "for example" are used to give an example, an illustration, or a description. Any embodiment or design scheme described as an "example" or "for example" in this application should not be explained as being more preferred or having more advantages than another embodiment or design scheme. Exactly, use of the terms such as "example" or "for example" is intended to present a related concept in a specific manner.

It should be noted that information (including but not limited to user equipment information, personal information of a user, and the like), data (including but not limited to data used for analysis, stored data, displayed data, and the like), and signals in this application are used under authorization by the user or full authorization by all parties, and collection, use, and processing of related data need to conform to related laws, regulations, and standards of related countries and regions. For example, all data written to a memory page in this application is obtained under full authorization.

All of the foregoing optional technical solutions may form optional embodiments of this disclosure through any combination. Details are not described herein.

The foregoing descriptions are merely optional embodiments of this application, but are not intended to limit this application. Any modification, equivalent replacement, or improvement made without departing from the spirit and principle of this application should fall within the protection scope of this application.

## Claims

1. A memory page processing method, wherein the method comprises:
when a first virtual address accessed by an application program causes a page fault, allocating a first memory page to the first virtual address;
padding the first memory page with first data, wherein the first data is data in a data sequence corresponding to a cache compression mode, and the cache compression mode is a data compression mode used when data written by the application program in a cache is migrated to the memory page; and
accessing the padded first memory page based on the first virtual address.

2. The method according to claim 1, wherein the padding the first memory page with the first data comprises:
padding the first memory page with the first data when the application program enables a memory pre-padding function, wherein the memory pre-padding function indicates to pad an empty memory page with the first data before the application program accesses the empty memory page.

3. The method according to claim 2, wherein before the padding the first memory page with the first data when the application program enables the memory pre-padding function, the method further comprises:
periodically enabling the memory pre-padding function for the application program based on a running status of the application program.

4. The method according to claim 2, wherein before the padding the first memory page with the first data when the application program enables the memory pre-padding function, the method further comprises:
when a type of the application program is a target type, enabling the memory pre-padding function for the application program, wherein the cache compression mode is applicable to the application program of the target type.

5. The method according to any one of claims 1 to 4, wherein the accessing the padded first memory page based on the first virtual address comprises:
receiving a first write request of the application program, wherein the first write request indicates to write second data to the first virtual address; and
updating the first data at a location corresponding to the first virtual address in the first memory page to the second data.

6. The method according to any one of claims 1 to 5, wherein a plurality of second memory pages are all used to store task data of a same computing task of the application program, the plurality of second memory pages are all padded with the first data, and the method further comprises:
receiving a second write request of the application program, wherein the second write request indicates to write the task data to a second virtual address; and
updating the first data at a location corresponding to the second virtual address in the plurality of second memory pages to the task data.

7. The method according to any one of claims 1 to 6, wherein
the first data is each piece of data in the data sequence;
the first data is S pieces of data that appear most frequently in the data sequence, wherein S is greater than 0; or
the first data is R consecutive pieces of data in the data sequence, wherein R is greater than 0.

8. The method according to any one of claims 1 to 6, wherein
the first data is S pieces of data that appear most frequently in a plurality of data sequences, wherein the plurality of data sequences correspond to different cache compression modes, and S is greater than 0; or
the first data is data shared by the plurality of data sequences.

9. A memory page processing method, wherein the method comprises:
obtaining an allocation notification message, wherein the allocation notification message is used to notify that a first memory page has been allocated to a first virtual address for a page fault caused by access of an application program to the first virtual address; and
padding the first memory page with first data, wherein the first data is data in a data sequence corresponding to a cache compression mode, and the cache compression mode is a data compression mode used when data written by the application program in a cache is migrated to the memory page.

10. The method according to claim 9, wherein the padding the first memory page with the first data comprises:
padding the first memory page with the first data when the application program enables a memory pre-padding function, wherein the memory pre-padding function indicates to pad an empty memory page with the first data before the application program accesses the empty memory page.

11. The method according to claim 10, wherein before the padding the first memory page with the first data when the application program enables the memory pre-padding function, the method further comprises:
periodically enabling the memory pre-padding function for the application program based on a running status of the application program.

12. The method according to claim 10, wherein before the padding the first memory page with the first data when the application program enables the memory pre-padding function, the method further comprises:
when a type of the application program is a target type, enabling the memory pre-padding function for the application program, wherein the cache compression mode is applicable to the application program of the target type.

13. A memory page processing device, wherein the device comprises:
a running apparatus, configured to: when a first virtual address accessed by an application program causes a page fault, allocate a first memory page to the first virtual address by running an operating system;
a memory padding apparatus, configured to pad the first memory page with first data, wherein the first data is data in a data sequence corresponding to a cache compression mode, and the cache compression mode is a data compression mode used when data written by the application program in a cache is migrated to the memory page; and
a memory management apparatus, configured to access the padded first memory page based on the first virtual address.

14. The device according to claim 13, wherein the memory padding apparatus is further configured to:
pad the first memory page with the first data when the application program enables a memory pre-padding function, wherein the memory pre-padding function indicates to pad an empty memory page with the first data before the application program accesses the empty memory page.

15. The device according to claim 14, wherein the memory padding apparatus is further configured to:
periodically enable the memory pre-padding function for the application program based on a running status of the application program.

16. The device according to claim 14, wherein the memory padding apparatus is further configured to:
when a type of the application program is a target type, enable the memory pre-padding function for the application program, wherein the cache compression mode is applicable to the application program of the target type.

17. The device according to any one of claims 13 to 16, wherein the memory management apparatus is configured to:
receive a first write request of the application program, wherein the first write request indicates to write second data to the first virtual address; and
update the first data at a location corresponding to the first virtual address in the first memory page to the second data.

18. The device according to claims 13 to 17, wherein a plurality of second memory pages are all used to store task data of a same computing task of the application program, the plurality of second memory pages are all padded with the first data, and the memory management apparatus is further configured to:
receive a second write request of the application program, wherein the second write request indicates to write the task data to a second virtual address; and
update the first data at a location corresponding to the second virtual address in the plurality of second memory pages to the task data.

19. The device according to any one of claims 13 to 18, wherein
the first data is each piece of data in the data sequence;
the first data is S pieces of data that appear most frequently in the data sequence, wherein S is greater than 0; or
the first data is R consecutive pieces of data in the data sequence, wherein R is greater than 0, and the first data is a hexadecimal value 0 or value F.

20. The device according to any one of claims 13 to 18, wherein
the first data is S pieces of data that appear most frequently in a plurality of data sequences, wherein the plurality of data sequences correspond to different cache compression modes, and S is greater than 0; or
the first data is data shared by the plurality of data sequences.

21. A memory padding apparatus, wherein the apparatus comprises:
an obtaining unit, configured to obtain an allocation notification message, wherein the allocation notification message is used to notify that a first memory page has been allocated to a first virtual address for a page fault caused by access of an application program to the first virtual address; and
a padding unit, configured to pad the first memory page with first data, wherein the first data is data in a data sequence corresponding to a cache compression mode, and the cache compression mode is a data compression mode used when data written by the application program in a cache is migrated to the memory page.

22. The apparatus according to claim 21, wherein the padding unit is further configured to:
pad the first memory page with the first data when the application program enables a memory pre-padding function, wherein the memory pre-padding function indicates to pad an empty memory page with the first data before the application program accesses the empty memory page.

23. An electronic device, wherein the electronic device comprises a processor, and the processor is configured to execute program code, to enable the electronic device to perform the method according to any one of claims 1 to 8.

24. A memory padding apparatus, wherein the memory padding apparatus comprises a processor, and the processor is configured to execute program code, to enable the memory padding apparatus to perform the method according to any one of claims 9 to 12.

25. A computer-readable storage medium, wherein the storage medium stores at least one piece of program code, and the at least one piece of program code is read by a processor, to perform the method according to any one of claims 1 to 12.
